# EUROPEAN PATENT APPLICATION

(11) **EP 4 810 902 A1**
(43) Date of publication of application: **23.09.2026**
(21) Application number: 24891469.9
(22) Date of filing: 14.11.2024
(51) Int. Cl.: G01B 17/02, C23C 14/24, C23C 14/52, G01N 5/02

(54) **SENSOR MODULE AND MEASURING SYSTEM**

(30) Priority: 15.11.2023 WO PCT/JP2023/041125
(71) Applicant: Nihon Dempa Kogyo Co., Ltd., Tokyo 151-8569 (JP)
(72) Inventor: ONISHI, Naoki, Sayama-shi, Saitama 350-1321 (JP); KUKITA, Hiroyuki, Sayama-shi, Saitama 350-1321 (JP)
(74) Representative: Plougmann Vingtoft a/s
(86) International application number: PCT/JP2024/040478
(87) International publication number: WO 2025/105433

(57) **Abstract**

This sensor module comprises a first piezoelectric vibrator having a first electrode, a second piezoelectric vibrator having a second electrode, an electrode cover covering one of the first electrode and the second electrode, an oscillation circuit for causing the first piezoelectric vibrator and the second piezoelectric vibrator to oscillate, and a storage circuit for storing initial oscillation frequency information relating to both the first piezoelectric vibrator and a second oscillation frequency, wherein, when at least the piezoelectric vibrator, among the first piezoelectric vibrator and the second piezoelectric vibrator, of which the electrode is not covered by the electrode cover is driven by the oscillation circuit, the piezoelectric vibrator oscillates at a frequency corresponding to the thickness of a deposit accumulated on the surface of the electrode that is exposed without being covered by the electrode cover.

## Description

### TECHNICAL FIELD

The present disclosure relates to a sensor module and a measurement system.

### BACKGROUND ART

Conventionally, a Quartz Crystal Microbalance (QCM) sensor using a quartz crystal resonator is known. The QCM sensor is capable of detecting the presence or absence of a substance based on a difference between a resonance frequency of a reference quartz crystal resonator and a resonance frequency of a detection quartz crystal resonator to which the substance adheres (see Patent Document 1).

### PRIOR ART

### PATENT DOCUMENT

Patent Document 1: Japanese Unexamined Patent Application Publication No. 2018-080947

### SUMMARY OF INVENTION

### PROBLEMS TO BE SOLVED BY THE INVENTION

Such a sensor can be used, by being installed in an apparatus that deposits a material, such as a semiconductor manufacturing apparatus, as a sensor that detects a thickness of the material deposited based on a change in a resonance frequency of a resonator on which the material has been deposited. However, as an amount of the material deposited on the resonator increases, the resonator may exceed its oscillation limit, and the sensor may become unable to operate while the semiconductor manufacturing apparatus is depositing the material.

The present disclosure focuses on this point, and an object thereof is to estimate a lifetime of a resonator mounted on a sensor that detects an amount of deposited material using the resonator.

### MEANS FOR SOLVING THE PROBLEMS

A first aspect of the present disclosure provides a sensor module including a first piezoelectric resonator that has a first electrode, a second piezoelectric resonator that has a second electrode, an electrode cover that covers one of the first electrode and the second electrode, an oscillation circuit that drives and oscillates each of the first piezoelectric resonator and the second piezoelectric resonator, and a storage circuit that stores, as initial oscillation frequency information, information corresponding to i) a first oscillation frequency measured by causing the first piezoelectric resonator to oscillate upon shipment of the first piezoelectric resonator and ii) a second oscillation frequency measured by causing the second piezoelectric resonator to oscillate upon shipment of the second piezoelectric resonator, wherein at least one of the first piezoelectric resonator and the second piezoelectric resonator that is not covered by the electrode cover oscillates, when driven by the oscillation circuit, at a frequency corresponding to a thickness of a deposit deposited on a surface of an electrode that is exposed and not covered by the electrode cover.

The storage circuit may further store information of a resonator identification number for identifying the first piezoelectric resonator and the second piezoelectric resonator.

The electrode cover may be switchable between a state in which the electrode cover covers the first electrode and a state in which the electrode cover covers the second electrode, the first piezoelectric resonator, when driven by the oscillation circuit, may oscillate at a frequency corresponding to a thickness of a deposit deposited on a surface of the first electrode, the second piezoelectric resonator, when driven by the oscillation circuit, may oscillate at a frequency corresponding to a thickness of a deposit deposited on a surface of the second electrode, and the electrode cover may expose the first electrode when covering the second electrode and preventing deposits from being deposited on the surface of the second electrode, and may expose the second electrode when covering the first electrode and preventing deposits from being deposited on the surface of the first electrode.

When the electrode cover is switched to a state of covering the first electrode after the first piezoelectric resonator is driven by the oscillation circuit, the storage circuit may store, as terminal oscillation frequency information, an oscillation frequency measured by causing the first piezoelectric resonator to oscillate.

The sensor module according to claim may include a plurality of combinations of the first piezoelectric resonator and the second piezoelectric resonator, wherein the electrode cover may be configured in a movable plate shape while covering the plurality of first electrodes and the plurality of second electrodes, the electrode cover may have a first opening for exposing one of the first electrodes and a second opening for exposing one of the second electrodes, the first opening may be disposed to sequentially move, as the electrode cover moves, to a plurality of positions corresponding to the plurality of first electrodes so as to expose the plurality of first electrodes one by one, the second opening may be disposed to sequentially move, as the electrode cover moves, to a plurality of positions corresponding to the plurality of second electrodes so as to expose the plurality of second electrodes one by one, and the sensor module may further include a moving unit that moves the electrode cover.

A plurality of the first piezoelectric resonators may be disposed along a circumference of a first circle having a predetermined radius on an upper surface of a fixed substrate, a plurality of the second piezoelectric resonators may be disposed along a circumference of a second circle concentric with the first circle on the upper surface of the fixed substrate, the electrode cover may be rotatably provided while covering a plurality of the first piezoelectric resonators and a plurality of the second piezoelectric resonators, in the electrode cover, the first opening may be provided on a circumference of a circle coinciding with the first circle in plan view, and the second opening may be provided on a circumference of a circle coinciding with the second circle in plan view, and the moving unit may expose either one of the first electrodes through the first opening or one of the second electrodes through the second opening, among a plurality of the first electrodes and a plurality of the second electrodes, by rotating the electrode cover about an axis passing through the center of the first circle perpendicularly in plan view as a rotation axis.

A second aspect of the present disclosure provides a measurement system including the sensor module according to the first aspect, and a control device that is connected to the sensor module, wherein the control device includes a memory control unit that is capable of accessing the storage circuit of the sensor module to read information stored in the storage circuit, a frequency measurement unit that measures oscillation frequencies of the first piezoelectric resonator and the second piezoelectric resonator, based on an oscillation frequency signal output from the oscillation circuit, a thickness determination unit that determines a thickness of the deposit deposited on a surface of an electrode that is exposed and not covered by the electrode cover among the first electrode of the first piezoelectric resonator and the second electrode of the second piezoelectric resonator, based on a measurement result obtained by the frequency measurement unit, and a lifetime estimation unit that estimates a lifetime of a piezoelectric resonator with an electrode that is exposed and not covered by the electrode cover among the first piezoelectric resonator and the second piezoelectric resonator, based on the initial oscillation frequency information read from the storage circuit by the memory control unit and a measurement result obtained by the frequency measurement unit.

The lifetime estimation unit may estimate a lifetime of the first piezoelectric resonator in response to an absolute value of a difference frequency between an oscillation frequency of the first piezoelectric resonator and an oscillation frequency of the second piezoelectric resonator becoming equal to or greater than a first threshold value based on the initial oscillation frequency information.

The storage circuit of the sensor module may further store information of the first threshold value based on the initial oscillation frequency information.

The storage circuit of the sensor module may further store information of a second threshold value having an absolute value smaller than that of the first threshold, and the lifetime estimation unit may determine that the end of a lifetime of the first piezoelectric resonator is approaching in response to an absolute value of a difference frequency between an oscillation frequency of the first piezoelectric resonator and an oscillation frequency of the second piezoelectric resonator becoming equal to or larger than the second threshold value.

A third aspect of the present disclosure provides a measurement system including the sensor module according to the first aspect, and a control device that is connected to the sensor module, wherein the control device includes a memory control unit that is capable of accessing the storage circuit of the sensor module to read information stored in the storage circuit, an instruction unit that instructs the sensor module to perform a switching operation of the electrode cover, a frequency measurement unit that measures oscillation frequencies of the first piezoelectric resonator and the second piezoelectric resonator, based on an oscillation frequency signal output from the oscillation circuit, a thickness determination unit that determines a thickness of the deposit deposited on a surface of an electrode exposed by an instruction of the instruction unit among the first electrode of the first piezoelectric resonator and the second electrode of the second piezoelectric resonator, based on a measurement result obtained by the frequency measurement unit, and a lifetime estimation unit that estimates a lifetime of a piezoelectric resonator having an electrode exposed by an instruction of the instruction unit, among the first piezoelectric resonator and the second piezoelectric resonator, based on initial oscillation frequency information read from the storage circuit by the memory control unit and a measurement result obtained by the frequency measurement unit.

A fourth aspect of the present disclosure provides a measurement system including the sensor module according to the first aspect, and a control device that is connected to the sensor module, wherein the control device includes a memory control unit that is capable of accessing the storage circuit of the sensor module to read information stored in the storage circuit, an instruction unit that instructs movement of the electrode cover so that i) the first opening is positioned at a position corresponding to the first piezoelectric resonator of one combination or ii) the second opening is positioned at a position corresponding to the second piezoelectric resonator of one combination, among a plurality of combinations of the first piezoelectric resonators and the second piezoelectric resonators, a frequency measurement unit that measures oscillation frequencies of the first piezoelectric resonator and the second piezoelectric resonator of the one combination, based on an oscillation frequency signal output from the oscillation circuit, a thickness determination unit that determines a thickness of the deposit deposited on a surface of an electrode exposed by an instruction of the instruction unit among the first electrode of the first piezoelectric resonator and the second electrode of the second piezoelectric resonator, based on a measurement result obtained by the frequency measurement unit, and a lifetime estimation unit that estimates a lifetime of a piezoelectric resonator having an electrode exposed in response to an instruction from the instructing unit, among the first piezoelectric resonator and the second piezoelectric resonator, based on the initial oscillation frequency information read from the storage circuit by the memory control unit and a measurement result obtained by the frequency measurement unit.

### EFFECT OF THE INVENTION

According to the present disclosure, it is possible to estimate a lifetime of a resonator mounted on a sensor that detects an amount of deposited material using the resonator.

### BRIEF DESCRIPTION OF THE DRAWINGS

FIG. 1 shows an example in which a measurement system S according to the present embodiment is applied to a semiconductor manufacturing apparatus 1.
FIG. 2 shows a first configuration example of a sensor module 10 according to the present embodiment.
FIG. 3 shows a configuration example of a control device 100 according to the present embodiment.
FIG. 4 shows an operational flow of the control device 100 according to the present embodiment.
FIG. 5 shows a second configuration example of the sensor module 10 according to the present embodiment.
FIG. 6 shows a third configuration example of the sensor module 10 according to the present embodiment.
FIG. 7 shows a fourth configuration example of the sensor module 10 according to the present embodiment.
FIG. 8 shows an example in which an electrode cover 35 of a sensor module 40 of the fourth configuration example shown in FIG. 7 is rotated.
FIG. 9 shows a fifth configuration example of the sensor module 10 according to the present embodiment.

### DESCRIPTION OF EMBODIMENTS

### <Example of measurement system S applied to semiconductor manufacturing apparatus 1>

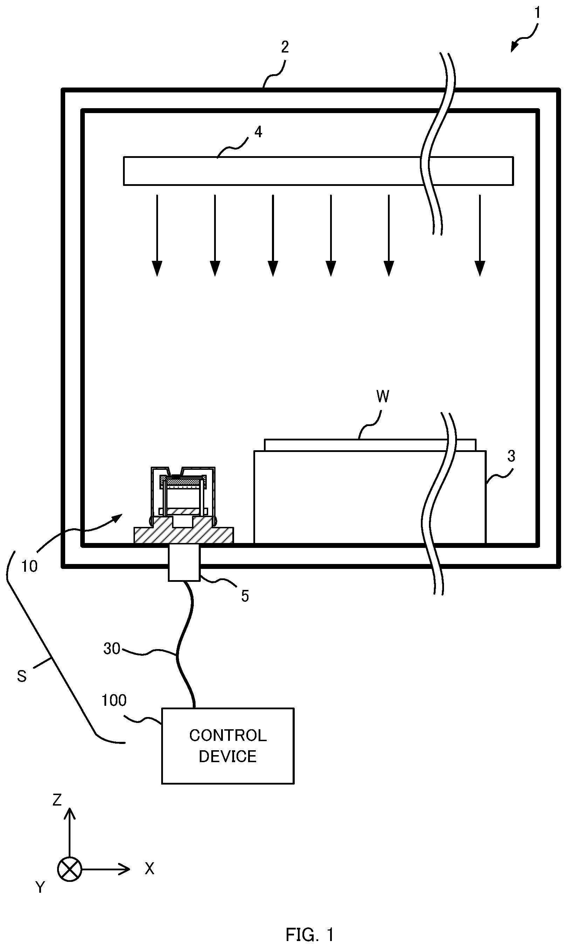

FIG. 1 shows an example in which a measurement system S according to the present embodiment is applied to a semiconductor manufacturing apparatus 1. The semiconductor manufacturing apparatus 1 is an apparatus for laminating a semiconductor material on a semiconductor wafer W. The semiconductor manufacturing apparatus 1 includes a chamber 2, a stage 3, and a film forming device 4.

The chamber 2 is a container that seals a predetermined space. The chamber 2 is a vacuum chamber capable of maintaining a sealed space at a reduced pressure, for example. The stage 3 is provided inside the chamber 2 and configured to support the semiconductor wafer W. The stage 3 may be configured to be movable in the chamber 2 while supporting the semiconductor wafer W.

The film forming device 4 is a device for depositing a material such as a metal, an insulator, or a semiconductor on a surface of the semiconductor wafer W. The film forming device 4 is a device that deposits a material by a liquid-phase method or a vapor-phase method, a device that applies a material, or the like. Various devices are known as the film forming device 4, and therefore a detailed description thereof is omitted herein. A semiconductor material is deposited on the surface of the semiconductor wafer W by such a film forming device 4, thereby forming a thin film.

In such a semiconductor manufacturing apparatus 1, a thickness of the semiconductor material deposited on the semiconductor wafer W can be estimated by using film forming conditions and a film forming time of the film forming device 4, for example. However, in some cases, it is desirable to measure an actual thickness of the semiconductor material deposited on the semiconductor wafer W. In particular, there are cases where it is desirable to measure the thickness of the semiconductor material in real time during deposition of the semiconductor material. Therefore, the measurement system S according to the present embodiment measures the thickness of the semiconductor material deposited on the surface of the semiconductor wafer W.

The measurement system S includes a sensor module 10, a connection cable 30, and a control device 100. The sensor module 10 is installed inside the chamber 2. Like the semiconductor wafer W, the sensor module 10 is provided in a region where the film forming device 4 can deposit a material, and measures the thickness of the material deposited thereon. The sensor module 10 and the control device 100 will be described later.

The connection cable 30 connects the sensor module 10 that is inside the chamber 2 and the control device 100 that is outside the chamber 2. The connection cable 30 connects the sensor module 10 and the control device 100 via a connector 5, for example. In this case, the connector 5 is provided in the chamber 2 and is configured to be capable of transmitting and receiving electrical signals while maintaining airtightness of the chamber 2. Next, the sensor module 10 of the measurement system S will be described.

### <First configuration example of sensor module 10>

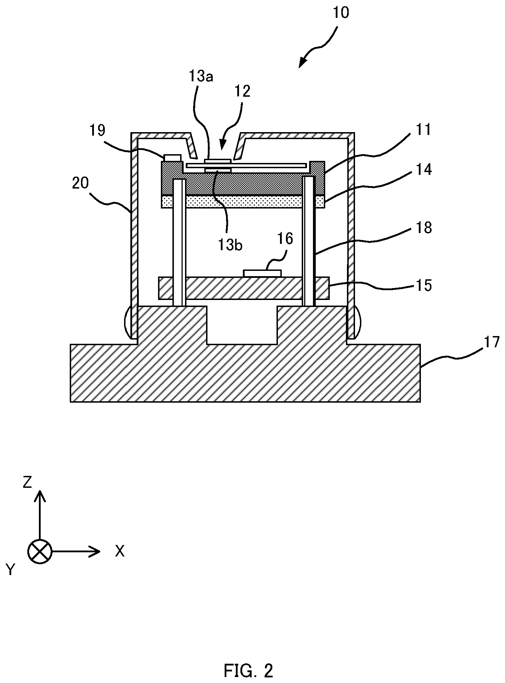

FIG. 2 shows a first configuration example of the sensor module 10 according to the present embodiment. In FIG. 2, three orthogonal axes are defined as an X-axis, a Y-axis, and a Z-axis. FIG. 2 schematically shows a cross section of the sensor module 10. The sensor module 10 includes a substrate 11, a piezoelectric resonator 12, a heater circuit 14, an oscillation circuit 15, a storage circuit 16, a base member 17, a coupling socket 18, a temperature sensor 19, and a cover 20.

The substrate 11 is a substrate for fixing the piezoelectric resonator 12. The substrate 11 is a ceramic substrate such as a Low Temperature Co-fired Ceramics (LTCC) substrate, for example.

The piezoelectric resonator 12 has an electrode 13, and oscillates, when driven by the oscillation circuit 15, at a frequency corresponding to a thickness of a deposit deposited on a surface of the electrode 13. The piezoelectric resonator 12 is a quartz crystal resonator, a ceramic resonator, a Langersite resonator, or the like, for example. In the present embodiment, an example in which the piezoelectric resonator 12 is a two-electrode quartz crystal resonator formed on a quartz substrate composed of a single quartz piece.

One electrode 13a of the piezoelectric resonator 12 is provided on a side opposite to the substrate 11, and is exposed to the outside. The other electrode 13b different from the electrode 13a of the piezoelectric resonator 12 is provided at a position not exposed to the outside. Thus, when the film forming device 4 of the semiconductor manufacturing apparatus 1 starts deposition of the semiconductor material, the semiconductor material is deposited on a surface of the electrode 13a of the piezoelectric resonator 12.

The heater circuit 14 adjusts a temperature of the piezoelectric resonator 12 via the substrate 11. The heater circuit 14 includes a heater that heats the piezoelectric resonator 12, for example. The heater is a Peltier element, a resistor, or a heating wire, for example. The heater may be provided on a surface of the substrate 11 opposite to the piezoelectric resonator 12, and alternatively may be provided on an inner layer of the substrate 11.

The heater circuit 14 has a function of adjusting an amount of heating based on a temperature of the substrate 11 measured by the temperature sensor 19. The heater circuit 14 includes a circuit that adjusts electric power to be supplied to the heater so as to maintain the temperature of the substrate 11 at a predetermined temperature or within a predetermined temperature range. The heater circuit 14 functions as, for example, a heating control unit that controls an amount of heating by the heater based on a difference between a temperature measured by the temperature sensor 19 and a target temperature.

The oscillation circuit 15 has a circuit for driving and oscillating the piezoelectric resonator 12 in accordance with a control signal from the control device 100. When the sensor module 10 includes a plurality of resonators, the oscillation circuit 15 includes circuits corresponding to the plurality of resonators, each circuit being configured to cause a respective resonator to oscillate. The oscillation circuit 15 outputs an oscillation signal of the piezoelectric resonator 12 as an oscillation frequency signal. The oscillation frequency signal output from the oscillation circuit 15 is input to the control device 100 via the connector 5 and the connection cable 30. The oscillation circuit 15 is formed on a predetermined circuit board.

The storage circuit 16 stores, as initial oscillation frequency information, an oscillation frequency measured by causing the piezoelectric resonator 12 to oscillate upon shipment of the piezoelectric resonator 12. The storage circuit 16 is a nonvolatile memory. The storage circuit 16 is preferably a memory readable and rewritable by an electrical signal.

The storage circuit 16 is configured to be capable of updating information by overwriting a storage area for information stored in the past, for example. Thus, when the storage area of the storage circuit 16 is filled with information, an old storage area can be overwritten to store the latest information. The storage circuit 16 may be formed on a circuit board on which the oscillation circuit 15 is formed, or may be formed on another circuit board instead.

The base member 17 is a member for fixing the oscillation circuit 15. The coupling socket 18 is a member for electrically connecting the oscillation circuit 15 and the piezoelectric resonator 12. For example, a pin (not shown in figures) that is electrically connected to the piezoelectric resonator 12 and protrudes from the substrate 11 is inserted into the coupling socket 18. Since the piezoelectric resonator 12 is connected to the oscillation circuit 15 via the pin and the coupling socket 18, even if the temperature varies over a wide range due to heating by the heater circuit 14 and expansion and contraction occurs in respective portions, the coupling socket 18 can absorb stress generated by the expansion and contraction.

The temperature sensor 19 measures a surface temperature of the substrate 11 on which the piezoelectric resonator 12 is provided. The temperature sensor 19 is a resistance temperature detector using platinum or the like, a thermocouple, a thermistor, or the like, for example. The temperature sensor 19 is preferably attached in contact with the substrate 11. In addition, the temperature sensor 19 may be attached in contact with the piezoelectric resonator 12.

The cover 20 covers a portion of the sensor module 10 excluding the electrode 13a, and has a through hole that exposes the electrode 13a. When such a sensor module 10 is installed inside the chamber 2 so that the electrode 13a faces the film forming device 4 of the semiconductor manufacturing apparatus 1, the electrode 13a is deposited with the same material as that deposited on the semiconductor wafer W by the film forming device 4, to the same thickness as on the semiconductor wafer W.

When a substance is deposited on the electrode 13a of the piezoelectric resonator 12, the resonance frequency of the piezoelectric resonator 12 changes in accordance with a thickness of the deposited substance. Therefore, the control device 100 of the measurement system S determines the thickness of a substance deposited on the electrode 13a by measuring such a change in the resonance frequency of the piezoelectric resonator 12. Such a control device 100 will be described below.

### <Configuration example of control device 100>

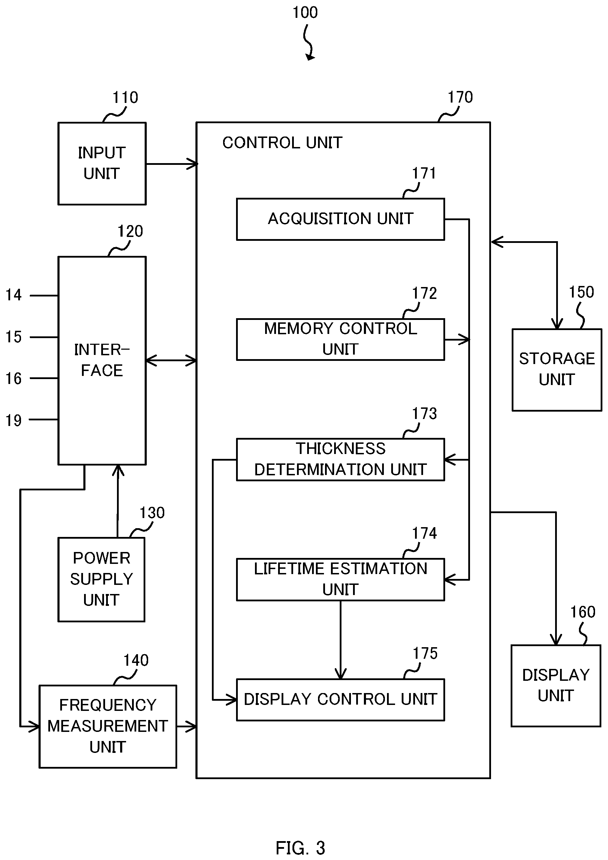

FIG. 3 shows a configuration example of the control device 100 according to the present embodiment. The control device 100 includes an input unit 110, an interface 120, a power supply unit 130, a frequency measurement unit 140, a storage unit 150, a display unit 160, and a control unit 170.

An operation, an instruction, or the like from a user of the control device 100 is input to the input unit 110. The input unit 110 is a part for the user to input a measurement condition for measuring the thickness of the deposit deposited on the sensor module 10. The input unit 110 includes one or more input devices such as a keyboard, a mouse, a touch panel, and a voice input device.

The interface 120 is connected to the connection cable 30 and is connected to the sensor module 10. The interface 120 is a part for transmitting and receiving electrical signals with the sensor module 10. For example, the interface 120 transmits and receives electrical signals between a) the heater circuit 14, the oscillation circuit 15, the storage circuit 16, and the temperature sensor 19 and b) the control device 100.

The power supply unit 130 supplies power to the sensor module 10. The power supply unit 130 is a circuit provided in the sensor module 10 and functions as a power source of the heater. The power supply unit 130 may vary supplied power based on a control operation of the control unit 170.

The frequency measurement unit 140 receives the oscillation frequency signal output from the oscillation circuit 15 via the interface 120. Then, the frequency measurement unit 140 measures the oscillation frequency of the piezoelectric resonator 12 based on the oscillation frequency signal. The frequency measurement unit 140 includes a frequency counter, for example, and measures the oscillation frequency of the oscillation frequency signal.

The frequency measurement unit 140 continuously measures the oscillation frequency of the oscillation frequency signal at least during a deposition period from a start to an end of a deposition operation of the semiconductor material performed by the film forming device 4 of the semiconductor manufacturing apparatus 1. For example, the frequency measurement unit 140 measures the oscillation frequency of the oscillation frequency signal at predetermined time intervals during the deposition period. The frequency measurement unit 140 supplies a measurement result to the control unit 170. The frequency measurement unit 140 preferably supplies the measurement result to the control unit 170 every time the oscillation frequency is measured.

The storage unit 150 is a storage medium including a Read Only Memory (ROM), a Random Access Memory (RAM), and the like. Further, the storage unit 150 may include a mass storage device such as a Hard Disk Drive (HDD) and/or a Solid State Drive (SSD). For example, when a computer or the like functions as at least a part of the control device 100, the storage unit 150 may store information such as an Operating System (OS) that causes the computer to function and a program. Furthermore, the storage unit 150 may store various kinds of information including a database referred to when the program is executed.

Moreover, the storage unit 150 may store intermediate data, a calculation result, a threshold value, a reference value, a parameter, and the like generated (or used) in the process of an operation of the control device 100. For example, the storage unit 150 may store information acquired from the sensor module 10 by the control device 100, or may store information to be written into the storage circuit 16 of the sensor module 10. In addition, the storage unit 150 may supply the stored data to a request source in response to a request from each unit in the control device 100.

The display unit 160 displays information related to the measurement of the thickness of the deposit. The display unit 160 may display a measurement condition, a measurement result, a connection state with the sensor module 10, information of the sensor module 10, and the like, for example. The display unit 160 may also function as a display for displaying the OS, an execution state of an application, and the like. The display unit 160 may have a touch panel function to operate as at least a part of the input unit 110.

The control unit 170 controls each unit of the control device 100 and the sensor module 10. The control unit 170 reads the information stored in the storage unit 150, for example. The control unit 170 may record information in the storage unit 150. For example, the control unit 170 transmits, to the oscillation circuit 15, a control signal for driving the oscillation circuit 15 to cause the oscillation circuit 15 to drive the piezoelectric resonator 12. A more specific operation of the control unit 170 will be described below.

The control unit 170 is a Central Processing Unit (CPU), for example. The control unit 170 includes an acquisition unit 171, a memory control unit 172, a thickness determination unit 173, a lifetime estimation unit 174, and a display control unit 175. In other words, the CPU functions as the control unit 170 including the acquisition unit 171, the memory control unit 172, the thickness determination unit 173, the lifetime estimation unit 174, and the display control unit 175 by executing the program stored in the storage unit 150.

The acquisition unit 171 acquires the measurement result of the oscillation frequency measured by the frequency measurement unit 140. Further, the acquisition unit 171 acquires the measurement result of the temperature of the substrate 11 obtained by the temperature sensor 19. The acquisition unit 171 supplies the acquired measurement result of the oscillation frequency and the measurement result of the temperature to the thickness determination unit 173 and the lifetime estimation unit 174.

The memory control unit 172 is configured to be capable of accessing the storage circuit 16 of the sensor module 10 and reading the information stored in the storage circuit 16. For example, the memory control unit 172 reads and acquires the initial oscillation frequency information stored in the storage circuit 16. The memory control unit 172 supplies the acquired initial oscillation frequency information to the lifetime estimation unit 174. The memory control unit 172 may be configured to be capable of accessing the storage circuit 16 of the sensor module 10 and writing predetermined information into the storage circuit 16.

The thickness determination unit 173 determines the thickness of the deposit deposited on the surface of the electrode 13a of the piezoelectric resonator 12 based on the oscillation frequency measured by the frequency measurement unit 140. The piezoelectric resonator 12 oscillates at a resonance frequency corresponding to the thickness of the deposit deposited on the surface of the electrode 13a. Therefore, the thickness determination unit 173 is capable of determining the thickness of the deposit after a predetermined time t has elapsed, based on a difference in the oscillation frequencies Δf=f2-f1, where f1 is the measurement result of the oscillation frequency at a time when the deposition operation of the semiconductor material performed by the film forming device 4 of the semiconductor manufacturing apparatus 1 is started and f2 is the measurement result of the oscillation frequency after the predetermined time t has elapsed from the start of the deposition operation.

It should be noted that the resonance frequency of the piezoelectric resonator 12 also varies depending on the temperature. Therefore, it is desirable that the thickness determination unit 173 performs temperature compensation on the measurement result of the oscillation frequency measured by the frequency measurement unit 140 using the measurement result of the temperature obtained by the temperature sensor 19. The temperature characteristics of the resonance frequency of the piezoelectric resonator 12 may be measured and determined in advance. Alternatively, when data is disclosed as specifications of the piezoelectric resonator 12, the disclosed data may be acquired. The temperature characteristics of the resonance frequency of the piezoelectric resonator 12 are preferably stored in the storage unit 150.

The thickness determination unit 173 determines a thickness dd of the deposit, for example, based on a difference in the oscillation frequencies Δf'=f2'-f1' calculated from compensated frequencies f1' and f2' obtained by performing the temperature compensation on the measurement results of the oscillation frequencies f1 and f2. A relational expression between the difference in the oscillation frequencies and the thickness of the deposit may be measured in advance to be determined. Alternatively, the relational expression may be determined based on a theoretical formula or the like. The determined relational expression is preferably stored in the storage unit 150. It should be noted that when the heater circuit 14 of the sensor module 10 maintains the temperature of the piezoelectric resonator 12 at a constant temperature, the temperature compensation on the measurement results of the oscillation frequencies f1 and f2 may be omitted.

The thickness determination unit 173 preferably determines the thickness of the deposit every time the frequency measurement unit 140 measures the oscillation frequency. Accordingly, the measurement system S can measure the thickness dd of the deposit deposited on the semiconductor wafer W in substantially real time.

The lifetime estimation unit 174 estimates a lifetime of the piezoelectric resonator 12 based on i) the initial oscillation frequency information read from the storage circuit 16 of the sensor module 10 by the memory control unit 172 and ii) the oscillation frequency measured by the frequency measurement unit 140. When the thickness of the deposit deposited on the surface of the electrode 13a reaches a predetermined thickness, the piezoelectric resonator 12 cannot perform an oscillation operation. The lifetime estimation unit 174 determines, as the lifetime, a measurable range up to a point at which the piezoelectric resonator 12 becomes unable to oscillate.

A deposit thickness dx at which the piezoelectric resonator 12 becomes unable to operate may be measured and determined in advance. Alternatively, when data is disclosed as specifications of the piezoelectric resonator 12, the disclosed data may be acquired. It is desirable that the deposit thickness dx at which the piezoelectric resonator 12 reaches the end of its lifetime is stored in the storage unit 150. Further, the storage circuit 16 of the sensor module 10 may store the deposit thickness dx at which the piezoelectric resonator 12 reaches the end of its lifetime.

The lifetime estimation unit 174 estimates the lifetime of the piezoelectric resonator 12 by comparing a) the compensated frequency obtained by performing the compensation, based on the surface temperature of the substrate 11, on the oscillation frequency measured by the frequency measurement unit 140 with b) the initial oscillation frequency information. For example, the lifetime estimation unit 174 determines a thickness dn of a deposit deposited on the electrode 13a in an initial state, based on a difference between the initial oscillation frequency information and an oscillation frequency Δf0'=f2'-f0, where f0 denotes the initial oscillation frequency information. An equation used by the lifetime estimation unit 174 to calculate the thickness of the deposit from the difference between the oscillation frequencies is the same as the equation used by the thickness determination unit 173 to calculate the thickness of the deposit.

It should be noted that there are some cases where the heater circuit 14 of the sensor module 10 maintains the temperature of the piezoelectric resonator 12 at a temperature at which the initial oscillation frequency information of the piezoelectric resonator 12 was measured. In this case, the lifetime estimation unit 174 may omit the temperature compensation on the oscillation frequency measurement result f2.

It should be noted that, when the piezoelectric resonator 12 in the initial state after shipment is mounted on the sensor module 10 and the thickness of the deposit is determined by the thickness determination unit 173 for the first time, the thickness dn of the deposit deposited on the electrode 13a in the initial state is equal to the thickness dd of the deposit determined by the thickness determination unit 173. When one or more measurements have been performed before the current measurement of the deposit thickness, a thickness obtained by adding the thickness dd of the deposit deposited by the current measurement to a thickness of a deposit deposited up to a previous measurement is equal to the thickness dn of the deposit deposited from the initial state of the electrode 13a.

The lifetime estimation unit 174 calculates a difference Δd=dx-dn between a) the deposit thickness dx at which the piezoelectric resonator 12 reaches the end of its lifetime and b) the determined deposit thickness dn. The difference Δd is a thickness of the deposit that can be measured by the piezoelectric resonator 12. For example, the lifetime estimation unit 174 determines a measurable deposit thickness Δd as the lifetime. Alternatively or additionally, the lifetime estimation unit 174 may calculate an oscillation frequency difference Δfx corresponding to the measurable deposit thickness Δd and determine the difference Δfx as the lifetime.

In addition, the lifetime estimation unit 174 may calculate an estimated lifetime corresponding to the measurable deposit thickness Δd. For example, the lifetime estimation unit 174 defines, as an estimated deposition rate vv, a value obtained by dividing a deposit thickness, which is determined based on oscillation frequency measurement results measured at two different times by the frequency measurement unit 140, by a time interval between the two times. Then, the lifetime estimation unit 174 defines, as an estimated lifetime vt, a value obtained by dividing the measurable deposit thickness Δd by the estimated deposition rate vv.

For example, when the deposit thickness dd after the predetermined time t has elapsed is determined, the lifetime estimation unit 174 calculates the estimated deposition rate vv as dd/t and the estimated lifetime vt as Δd/vv=Δd·t/dd. The lifetime estimation unit 174 may determine the estimated lifetime vt calculated in this manner as the lifetime. Accordingly, the lifetime estimation unit 174 can determine, as the lifetime, a time required for the piezoelectric resonator 12 to reach the measurement limit when the deposition is performed at a constant deposition rate.

The lifetime estimation unit 174 preferably estimates the lifetime of the piezoelectric resonator 12 every time the frequency measurement unit 140 measures the oscillation frequency. Accordingly, the measurement system S can measure the lifetime of the piezoelectric resonator 12 of the sensor module 10 in substantially real time.

The display control unit 175 displays, as the measurement result obtained by the measurement system S, the deposit thickness determined by the thickness determination unit 173 and the lifetime of the piezoelectric resonator 12 estimated by the lifetime estimation unit 174 on the display unit 160. This allows the user of the measurement system S to grasp the thickness of the deposited semiconductor material and the lifetime of the piezoelectric resonator 12 of the sensor module 10 while depositing the semiconductor material on the semiconductor wafer W using the semiconductor manufacturing apparatus 1. Thus, the user can determine an appropriate timing for replacing the sensor module 10.

For example, after the deposition operation of the semiconductor material by the film forming device 4 of the semiconductor manufacturing apparatus 1 is completed, the lifetime of the piezoelectric resonator 12 estimated by the lifetime estimation unit 174 indicates a measurement limit up to which the measurement system S can measure the next deposit thickness. Therefore, the user can easily determine whether to continue an operation of the semiconductor manufacturing apparatus 1 or to resume the operation after replacing the sensor module 10.

It should be noted that the control device 100 may measure the lifetime of the piezoelectric resonator 12 immediately after being powered on and becoming ready to measure a deposit thickness. In addition, the control device 100 may measure the lifetime of the piezoelectric resonator 12 in response to the user inputting the measurement condition to the input unit 110. Thus, the user can easily determine whether to replace the sensor module 10 before starting the operation of the semiconductor manufacturing apparatus 1. Next, the operation of the control device 100 will be described.

### <Operational flow of control device 100>

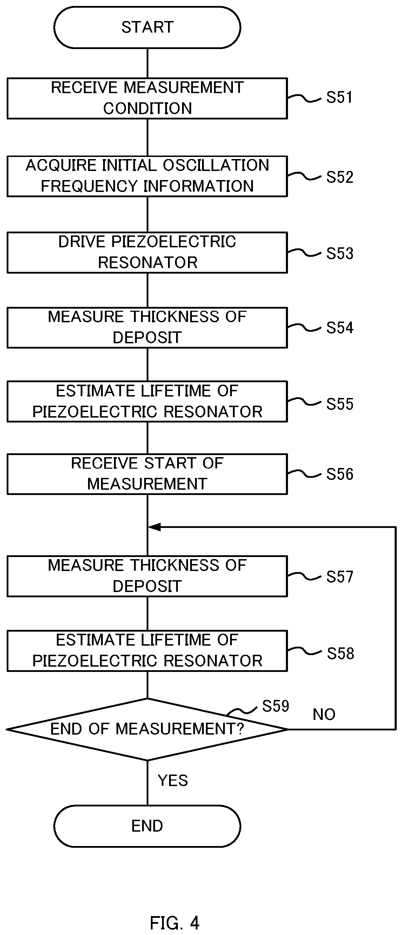

FIG. 4 shows an operational flow of the control device 100 according to the present embodiment. First, the input unit 110 receives the measurement condition input by the user (S51). The measurement condition may include information on the thickness of the semiconductor material to be deposited on the semiconductor wafer W. Next, the memory control unit 172 accesses the storage circuit 16 of the sensor module 10 and reads and acquires the initial oscillation frequency information stored in the storage circuit 16 (S52). Then, the control unit 170 causes the oscillation circuit 15 to drive the piezoelectric resonator 12 (S53).

Next, the control unit 170 measures the thickness of the deposit deposited on the piezoelectric resonator 12 (S54). In this case, the frequency measurement unit 140 measures the oscillation frequency of the piezoelectric resonator 12, and the acquisition unit 171 acquires the measurement result of the oscillation frequency and the measurement result of the temperature obtained by the temperature sensor 19. Then, the thickness determination unit 173 measures the thickness of the deposit deposited on the piezoelectric resonator 12 based on the measurement result of the oscillation frequency and the measurement result of the temperature. The display control unit 175 displays the determined deposit thickness on the display unit 160.

Subsequently, the control unit 170 estimates the lifetime of the piezoelectric resonator 12 (S55). In this case, the lifetime estimation unit 174 estimates the lifetime of the piezoelectric resonator 12 based on the measurement result of the oscillation frequency, the measurement result of the temperature, and the initial oscillation frequency information. The display control unit 175 displays the estimated lifetime of the piezoelectric resonator 12 on the display unit 160. Thus, the user can grasp the information on the piezoelectric resonator 12 before the semiconductor material is deposited on the semiconductor wafer W.

Next, the input unit 110 receives an indication to start measurement from the user (S56). Here, for example, it is assumed that the user inputs an instruction to start measurement to the input unit 110 in response to the start of deposition of the semiconductor material by the film forming device 4 of the semiconductor manufacturing apparatus 1. Alternatively, when a measurement start time is included in the measurement conditions input by the user, the control unit 170 may start the measurement in response to the measurement start time being reached. Further, the control device 100 may be connected to a control device that controls the operation of the semiconductor manufacturing apparatus 1 via a network or the like, and in this case, the control device 100 may receive a start signal for starting measurement from the control device of the semiconductor manufacturing apparatus 1.

The control device 100 measures the deposit thickness in the same manner as the operation of S54 (S57), and estimates the lifetime of the piezoelectric resonator 12 in the same manner as the operation of S55 (S58). The control device 100 repeats the operations of S57 and S58 (S59: No) until the input unit 110 receives an instruction to end the measurement (S59: Yes). Here, it is assumed that the user inputs the instruction to end the measurement to the input unit 110 in response to, for example, completion of the deposition of the semiconductor material by the film forming device 4 of the semiconductor manufacturing apparatus 1. Alternatively, when the measurement end time is included in the measurement conditions input by the user, the control unit 170 may end the measurement in response to the measurement end time being reached. Further, the control device 100 may receive an end signal for ending the measurement from the control device of the semiconductor manufacturing apparatus 1.

According to the measurement system S of the present embodiment described above, by storing the initial oscillation frequency information of the piezoelectric resonator 12 in the storage circuit 16 of the sensor module 10, the memory control unit 172 of the control device 100 can read the initial oscillation frequency information and estimate the lifetime of the piezoelectric resonator 12. Thus, when the semiconductor manufacturing apparatus 1 deposits the semiconductor material on the semiconductor wafer W, the lifetime of the piezoelectric resonator 12 can be measured while measuring the thickness of the deposited semiconductor material in substantially real time.

Therefore, the user can replace the sensor module 10 at an appropriate timing, and it is possible to prevent the piezoelectric resonator 12 from being unable to operate while the semiconductor manufacturing apparatus 1 is depositing the semiconductor material. In addition, when the sensor module 10 is replaced, the control device 100 reads the initial oscillation frequency information stored in the storage circuit 16 of the sensor module 10 after replacement, thereby estimating the lifetime of the piezoelectric resonator 12 after replacement.

### <Other configurations>

In the measurement system S according to the present embodiment described above, the user replaces the sensor module 10 before the piezoelectric resonator 12 becomes unable to operate. The user may replace the piezoelectric resonator 12 of the sensor module 10. When the user replaces the piezoelectric resonator 12 of the sensor module 10, the measurement system S may update the initial oscillation frequency information of the piezoelectric resonator 12 before replacement in the storage circuit 16 to the initial oscillation frequency information of the piezoelectric resonator 12 after replacement.

In this case, for example, the frequency measurement unit 140 measures the oscillation frequency of the piezoelectric resonator 12 after replacement, and the memory control unit 172 writes, as the initial oscillation frequency information, the measurement result obtained by the frequency measurement unit 140 in the storage circuit 16. Thus, the measurement system S can estimate the lifetime of the piezoelectric resonator 12 after replacement.

An example has been described in which, in the measurement system S according to the present embodiment described above, the initial oscillation frequency information of the piezoelectric resonator 12 is stored in the storage circuit 16 of the sensor module 10, but the present disclosure is not limited thereto. In addition to the above, the storage circuit 16 may store information of at least one of a first identification number for identifying the piezoelectric resonator 12 or a second identification number for identifying the sensor module 10.

When the storage circuit 16 stores the first identification number and/or the second identification number, the memory control unit 172 may read the first identification number and/or the second identification number when reading the initial oscillation frequency information. In this case, the display control unit 175 causes the display unit 160 to display the read first identification number and/or second identification number. Accordingly, the user can grasp information for identifying the sensor module 10 and/or the piezoelectric resonator 12 to be used for measurement and utilize the information for maintenance, management, and the like of the sensor module 10 and/or the piezoelectric resonator 12.

An example has been described in which, in the measurement system S according to the present embodiment described above, the storage circuit 16 stores, as the initial oscillation frequency information, the oscillation frequency measured by causing the piezoelectric resonator 12 to oscillate upon shipment of the piezoelectric resonator 12 by the storage circuit 16, but the present disclosure is not limited thereto. The storage circuit 16 may record information for estimating the lifetime of the piezoelectric resonator 12.

For example, the storage circuit 16 may store, as the initial oscillation frequency information, an oscillation frequency measured by causing the piezoelectric resonator 12 to oscillate when the measurement system S is installed. For example, when the frequency measurement unit 140 measures the oscillation frequency of the piezoelectric resonator 12 after the input unit 110 receives a predetermined operation indicating that the measurement system S is installed, the memory control unit 172 updates the initial oscillation frequency information stored in the storage circuit 16 to the measured oscillation frequency information of the piezoelectric resonator 12.

Thus, for example, when the measurement system S is applied to the semiconductor manufacturing apparatus 1 to construct a semiconductor manufacturing system, the storage circuit 16 can reliably store an initial value of the piezoelectric resonator 12 actually mounted on the sensor module 10. In addition, the storage circuit 16 may further store information on environmental temperature at the time of measuring the initial oscillation frequency information. It should be noted that although an example in which the measurement system S according to the present embodiment is applied to the semiconductor manufacturing apparatus 1 has been described, this is merely an example. The measurement system S is applicable not only to the semiconductor manufacturing apparatus 1 but also to any apparatus that deposits a deposit.

In the present embodiment described above, an example in which the sensor module 10 includes a single piezoelectric resonator 12 has been described, but the present disclosure is not limited thereto. The sensor module 10 may include a plurality of piezoelectric resonators 12. Therefore, the sensor module 10 having two piezoelectric resonators 12 will be described below.

### <Second configuration example of sensor module 10>

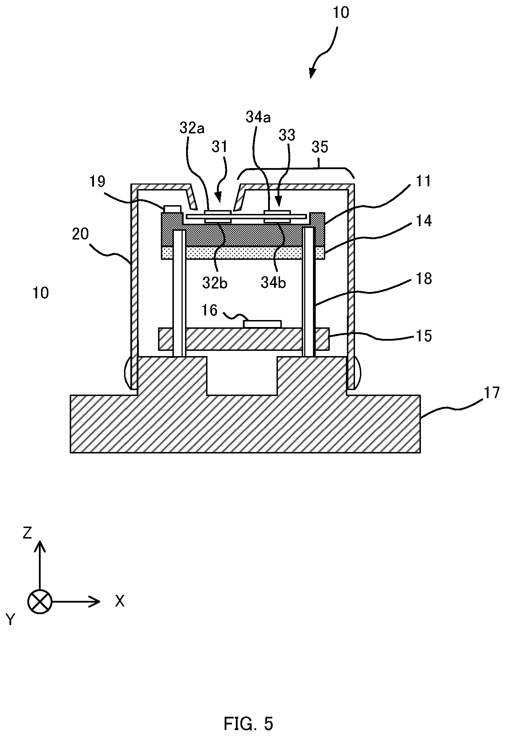

FIG. 5 shows a second configuration example of the sensor module 10 according to the present embodiment. In the sensor module 10 of the second configuration example, components that are substantially the same as those of the sensor module 10 of the first configuration example shown in FIG. 2 are denoted by the same reference numerals, and redundant descriptions thereof are omitted. The sensor module 10 of the second configuration example further includes a first piezoelectric resonator 31, a second piezoelectric resonator 33, and an electrode cover 35.

The first piezoelectric resonator 31 includes a first electrode 32. The second piezoelectric resonator 33 has a second electrode 34. The first piezoelectric resonator 31 and the second piezoelectric resonator 33 are similar to the piezoelectric resonator 12 described with reference to FIG. 2. For example, the first electrode 32 and the second electrode 34 are two-electrode electrodes, one electrode 32a and one electrode 34a are provided on a side opposite to the substrate 11, so that electrode surfaces face the outside of the sensor module 10. The other electrode 32b and the other electrode 34b of the first electrode 32 and second electrode 34, which face the substrate 11, are provided at positions not exposed to the outside.

As described above, since the electrode 32b (electrode 34b) is not exposed to the outside, it may be expressed as "the first electrode 32 (second electrode 34) is exposed" when the electrode 32a is exposed to the outside, "the first electrode 32 (second electrode 34) is covered by the electrode cover 35" when the electrode 32a is covered by the electrode cover 35, and "a deposit is deposited on the first electrode 32 (second electrode 34)" when the deposit is deposited on the electrode 32a.

The electrode cover 35 covers one of the first electrode 32 and the second electrode 34. FIG. 5 shows an example in which the electrode cover 35 is a part of the cover 20, and the electrode cover 35 covers the second electrode 34 of the second piezoelectric resonator 33 so as not to be exposed to the outside. The cover 20 covers a portion of the first piezoelectric resonator 31 excluding the first electrode 32. In other words, the first electrode 32 is exposed to the outside by the cover 20 and the electrode cover 35.

The heater circuit 14 adjusts the temperatures of the first piezoelectric resonator 31 and the second piezoelectric resonator 33 via the substrate 11. The oscillation circuit 15 drives and oscillates each of the first piezoelectric resonator 31 and the second piezoelectric resonator 33. The storage circuit 16 stores, as the initial oscillation frequency information, information corresponding to a first oscillation frequency (hereinafter, referred to as f₁0) measured by causing the first piezoelectric resonator 31 to oscillate upon shipment of the first piezoelectric resonator 31 and a second oscillation frequency (hereinafter, referred to as f₂0) measured by causing the second piezoelectric resonator 33 to oscillate upon shipment of the second piezoelectric resonator 33.

The storage circuit 16 may further store information of resonator identification numbers for identifying the first piezoelectric resonator 31 and the second piezoelectric resonator 33. In addition, the storage circuit 16 may store information indicating which of the first piezoelectric resonator 31 and the second piezoelectric resonator 33 is exposed (not exposed) in association with the resonator identification number.

Since the first electrode 32 of the first piezoelectric resonator 31 is exposed to the outside, when the sensor module 10 is provided inside the film forming device 4, a deposit such as a semiconductor material is deposited on the first electrode 32, for example. When driven by the oscillation circuit 15, the first piezoelectric resonator 31 oscillates at a frequency corresponding to a thickness of the deposit deposited on a surface of the electrode 32a that is exposed and not covered by the electrode cover 35. In other words, among the first piezoelectric resonator 31 and the second piezoelectric resonator 33, the piezoelectric resonator whose electrode is not covered by the electrode cover 35 operates as a piezoelectric resonator for detection like the piezoelectric resonator 12 described with reference to FIG. 2.

On the other hand, since the second electrode 34 of the second piezoelectric resonator 33 is not exposed to the outside, the deposit such as the semiconductor material is not deposited on the second electrode 34 even when the sensor module 10 is provided inside the film forming device 4. Therefore, the second piezoelectric resonator 33 oscillates at a frequency corresponding to the initial state upon shipment of the second piezoelectric resonator 33. In other words, the second piezoelectric resonator 33 operates as a piezoelectric resonator for reference, serving as a reference in a state in which no deposit is deposited. Accordingly, the control device 100 of the measurement system S determines a thickness of a substance deposited on the first electrode 32 by using such a first piezoelectric resonator 31 and second piezoelectric resonator 33.

### <Operation of control device 100 using sensor module 10 of second configuration example>

The control device 100 shown in FIG. 3 can also use the sensor module 10 of the second configuration example. Also in this case, the control device 100 is connected to the sensor module 10 of the second configuration example via the interface 120.

The frequency measurement unit 140 receives the oscillation frequency signals of the first piezoelectric resonator 31 and the second piezoelectric resonator 33 output from the oscillation circuit 15 via the interface 120. The frequency measurement unit 140 measures the oscillation frequencies of the first piezoelectric resonator 31 and the second piezoelectric resonator 33 based on the oscillation frequency signal output from the oscillation circuit 15. The frequency measurement unit 140 supplies measurement results to the control unit 170.

The memory control unit 172 of the control unit 170 reads and acquires the initial oscillation frequency information of the first piezoelectric resonator 31 and the second piezoelectric resonator 33 stored in the storage circuit 16. Then, the thickness determination unit 173 of the control unit 170 determines the thickness of the deposit deposited on the surface of the electrode that is exposed and not covered by the electrode cover 35 (in this example, the first electrode 32), of the first electrode 32 of the first piezoelectric resonator 31 and the second electrode 34 of the second piezoelectric resonator 33, based on the measurement results obtained by the frequency measurement unit 140.

The thickness determination unit 173 may determine the thickness of the deposit in the same manner as the operation described with reference to FIG. 3. For example, the measurement result of the oscillation frequency of the first piezoelectric resonator 31 at the start of the deposition operation of the semiconductor material by the film forming device 4 of the semiconductor manufacturing apparatus 1 is denoted by f₁1, and the measurement result of the oscillation frequency of the second piezoelectric resonator 33 is denoted by f₂1. Further, the measurement result of the oscillation frequency of the first piezoelectric resonator 31 after the predetermined time t has elapsed from the start of the deposition operation is denoted by f₁2, and the measurement result of the oscillation frequency of the second piezoelectric resonator 33 after the predetermined time t has elapsed from the start of the deposition operation is denoted by f₂2. For example, the thickness determination unit 173 can determine the thickness dd of the deposit after the predetermined time t has elapsed based on a difference in the oscillation frequencies Δf1 = f₁2-f₁1.

Alternatively, the thickness determination unit 173 may determine the thickness dd of the deposit after the predetermined time t has elapsed based on a difference in the oscillation frequencies Δf2 = f₁2-f₂1 using the measurement result f₂1 of the oscillation frequency of the second piezoelectric resonator 33 at the start of the deposition operation. Further, the thickness determination unit 173 may determine the thickness dd of the deposit based on a difference between Δf2 and the difference frequency at the start of the deposition operation Δf2₀ = f₁1-f₂1, that is, based on Δf2-Δf2₀.

It should be noted that since no substance is deposited on the second piezoelectric resonator 33 even after the predetermined time t has elapsed, ideally, f₂1 = f₂2. However, f₂1 ≠ f₂2 may occur due to a change in ambient temperature or the like of the second piezoelectric resonator 33. Therefore, the thickness determination unit 173 may determine the thickness dd of the deposit after the predetermined time t has elapsed based on Δf2" = f₁2-f₂2, by using f₂2 instead of f₂1. Further, the thickness determination unit 173 may determine the thickness dd of the deposit based on a difference between Δf2" and the difference frequency at the start of the deposition operation Δf2₀ = f₁1-f₂1, that is, based on Δf2"-Δf2₀.

Further, the thickness determination unit 173 may determine the thickness dd of the deposit based on a difference in the oscillation frequencies Δf1' = f₁2'-f₁1', Δf2' = f₁2'-f₂1', or Δf2" = f₁2'-f₂2' , the difference being calculated using compensated frequencies f₁1', f₁2', f₂1', and f₂2', which are obtained by performing temperature compensation on the measurement results of oscillation frequencies f₁1, f₁2, f₂1, and f₂2.

Based on the initial oscillation frequency information read from the storage circuit 16 by the memory control unit 172 and the measurement result obtained by the frequency measurement unit 140, the lifetime estimation unit 174 estimates the lifetime of the piezoelectric resonator having the electrode that is exposed and not covered by the electrode cover 35 (the first electrode 32 in the present example) of the first piezoelectric resonator 31 and the second piezoelectric resonator 33. The lifetime estimation unit 174 may estimate the lifetime of the deposit in the same manner as the operation described with reference to FIG. 3.

In addition, the lifetime estimation unit 174 estimates the lifetime of the first piezoelectric resonator 31 in response to an absolute value of a difference frequency between a) the oscillation frequency f₁2 of the first piezoelectric resonator 31 and b) the oscillation frequency f₂1 (or f₂2) of the second piezoelectric resonator 33, that is, |Δf2| (or |Δf2"|) becoming equal to or greater than a first threshold value based on the initial oscillation frequency information. For example, it is assumed that the first piezoelectric resonator 31 is a resonator that reaches the end of its lifetime when the oscillation frequency f₁2 is reduced by 95 kHz from the first frequency f₁0 which is the initial frequency. Here, a frequency of 95 kHz, indicating an index at which the first piezoelectric resonator 31 reaches the end of its lifetime, is defined as fₜ₁. In this case, the first threshold value may be set to be fₜ₁.

It should be noted that the first frequency f₁0, which is the initial frequency of the first piezoelectric resonator 31, and the second frequency f₂0, which is the initial frequency of the second piezoelectric resonator 33, may differ from each other due to variations among individual resonators and the like. In this case, the first threshold value may be a value obtained by adding, to fₜ₁, the difference between the first frequency f₁0 and the second frequency f₂0. For example, a difference between the initial frequencies of the first piezoelectric resonator 31 and the second piezoelectric resonator 33, that is (f₂0-f₁0), is 5 kHz. In this case, the first threshold value is set to be fₜ₁+(f₂0-f₁0) = 100kHz.

As described above, the lifetime estimation unit 174 can estimate the lifetime of the first piezoelectric resonator 31 by comparing the oscillation frequency f₁2 of the first piezoelectric resonator 31 and the oscillation frequency f₂1 (or f₂2) of the second piezoelectric resonator 33. The lifetime estimation unit 174 may compare the oscillation frequency f₁2 of the first piezoelectric resonator 31 and the oscillation frequency f₂1 (or f₂2) of the second piezoelectric resonator 33 after performing the temperature compensation. Alternatively, if the temperature characteristics of the two piezoelectric resonators are substantially the same, the lifetime estimation unit 174 is not required to perform the temperature compensation on the oscillation frequency. In this way, the lifetime estimation unit 174 can estimate the lifetime of the first piezoelectric resonator 31 more easily.

It should be noted that the storage circuit 16 of the sensor module 10 may further store information of the first threshold value based on the initial oscillation frequency information. Accordingly, the control device 100 can promptly obtain information used for determining the lifetime of the piezoelectric resonator even when replacement of a connected sensor module 10 is performed, for example.

The storage circuit 16 of the sensor module 10 may further store information of a second threshold value having an absolute value smaller than that of the first threshold value. For example, the lifetime estimation unit 174 determines that the end of the lifetime of the first piezoelectric resonator 31 is approaching in response to the absolute value of the difference frequency between the oscillation frequency of the first piezoelectric resonator 31 and the oscillation frequency of the second piezoelectric resonator 33 becoming equal to or larger than the second threshold value.

This allows the user to recognize that a time for replacing the sensor module 10 is approaching. For example, when a semiconductor material is scheduled to be deposited to form a thicker film, the user can consider replacing the sensor module 10 in advance, thereby reducing a possibility that the sensor module 10 becomes unable to operate as a sensor during deposition of the semiconductor material by the semiconductor manufacturing apparatus.

In the sensor module 10 of the second configuration example describe above, an example in which one of the two piezoelectric resonators is used as a piezoelectric resonator for detection and the other is used as a piezoelectric resonator for reference has been described, but the present disclosure is not limited thereto. In addition, the sensor module 10 may use the piezoelectric resonator used for detection as the piezoelectric resonator for reference, and may use the piezoelectric resonator used for reference as the piezoelectric resonator for detection. Such a sensor module 10 will be described below.

### <Third configuration example of sensor module 10>

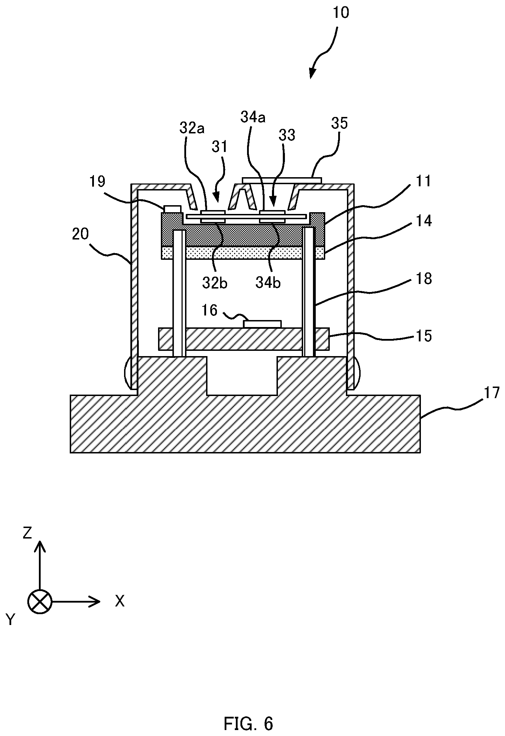

FIG. 6 shows a third configuration example of the sensor module 10 according to the present embodiment. In the sensor module 10 of the third configuration example, components that are substantially the same as those of the sensor module 10 of the second configuration example shown in FIG. 5 are denoted by the same reference numerals, and redundant descriptions thereof are omitted.

The sensor module 10 of the third configuration example is configured to be switchable between a state in which the electrode cover 35 covers the first electrode 32 and a state in which the electrode cover 35 covers the second electrode 34. FIG. 6 shows an example in which the cover is a plate-shaped member, and the electrode cover 35 slides to switch between a state in which the electrode cover 35 covers the first electrode 32 and a state in which the cover 35 covers the second electrode 34. Alternatively, the electrode cover 35 may be an openable/closable lid-shaped member, a door-shaped member, a shutter-shaped member, or the like provided in the cover 20.

The electrode cover 35 preferably includes an actuator or the like and is configured to be switchable, by an electrical signal, a state of covering the first electrode 32 and a state of covering the second electrode 34. In addition, the electrode cover 35 may be configured to be manually switched.

For example, when the electrode cover 35 covers the second electrode 34 to prevent deposits from being deposited on the surface of the second electrode 34, the first electrode 32 is exposed. In this case, when driven by the oscillation circuit 15, the first piezoelectric resonator 31 oscillates at a frequency corresponding to the thickness of the deposit deposited on the surface of the first electrode 32, and operates as the piezoelectric resonator for detection that is used for detecting the thickness of the deposit. The second piezoelectric resonator 33 operates as the piezoelectric resonator for reference.

When the electrode cover 35 covers the first electrode 32 to prevent deposits from being deposited on the surface of the first electrode 32, the second electrode 34 is exposed. In this case, when driven by the oscillation circuit 15, the second piezoelectric resonator 33 oscillates at a frequency corresponding to the thickness of the deposit deposited on the surface of the second electrode 34, and operates as the piezoelectric resonator for detection that is used for detecting the thickness of the deposit. The first piezoelectric resonator 31 operates as the piezoelectric resonator for reference.

It should be noted that the first piezoelectric resonator 31 and the second piezoelectric resonator 33 may first operate as the piezoelectric resonators for detection, whereby deposits are deposited on the electrodes, and may subsequently operate as the piezoelectric resonators for reference. In this case, a reference frequency by the first piezoelectric resonator 31 or the second piezoelectric resonator 33 is a frequency corresponding to the thickness of the deposit deposited on the surface of the electrode. This allows the sensor module 10 to be used by switching between the piezoelectric resonator for detection and the piezoelectric resonator for reference, thereby extending the lifetime of the sensor module 10.

For example, when the electrode cover 35 is switched to a state of covering the first electrode 32 after the first piezoelectric resonator 31 is driven by the oscillation circuit 15, it is preferable that the storage circuit 16 of such a sensor module 10 of the third configuration example stores, as terminal oscillation frequency information, an oscillation frequency measured by causing the first piezoelectric resonator 31 to oscillate. Accordingly, when the first piezoelectric resonator 31 is used as the piezoelectric resonator for reference, the control device 100 can quickly acquire information on the reference frequency.

Further, the storage circuit 16 may store information indicating whether the first piezoelectric resonator 31 and/or the second piezoelectric resonator 33 is the piezoelectric resonator for detection or the piezoelectric resonator for reference. In addition, the storage circuit 16 may store information indicating that the first piezoelectric resonator 31 and/or the second piezoelectric resonator 33 cannot be used as the piezoelectric resonator for detection when the first piezoelectric resonator 31 and/or the second piezoelectric resonator 33 has reached the end of its lifetime while operating as the piezoelectric resonator for detection. This allows the control device 100 to promptly determine, for example, which of the first piezoelectric resonator 31 and the second piezoelectric resonator 33 is to be used as the resonator for detection (reference), even when the sensor module 10 in use is connected.

### <Operation of control unit 100 using sensor module 10 of third configuration example>

The control device 100 shown in FIG. 3 can also use the sensor module 10 of the third configuration example. Also in this case, the control device 100 is connected to the sensor module 10 of the third configuration example via the interface 120. It should be noted that the operation of the frequency measurement unit 140 and the memory control unit 172 may be the same as the operation of the control device 100 using the sensor module 10 of the second configuration example, and a description thereof will be omitted here.

It is preferable that the control unit 170 further includes an instruction unit that instructs the sensor module 10 to perform the switching operation of the electrode cover. Accordingly, when the electrode cover 35 of the sensor module 10 is configured to be switchable, by an electrical signal, between a state in which the electrode cover 35 covers the first electrode 32 and a state in which the electrode cover 35 covers the second electrode 34, the control device 100 can switch the electrode cover 35 by supplying, to the sensor module 10, a control signal instructing the switching operation.

The thickness determination unit 173 determines, based on the measurement result obtained by the frequency measurement unit 140, the thickness of the deposit deposited on the surface of the electrode of the piezoelectric resonator for detection among the first electrode 32 of the first piezoelectric resonator 31 and the second electrode 34 of the second piezoelectric resonator 33. For example, when the information read from the storage circuit 16 by the memory control unit 172 includes the information on the piezoelectric resonator for detection, the thickness determination unit 173 determines the thickness of the deposit deposited on the surface of the electrode of the piezoelectric resonator for detection.

Alternatively, the information on the piezoelectric resonator for detection may be stored in the storage unit 150 of the control device 100. In this case, the thickness determination unit 173 determines, based on the information read from the storage unit 150, the thickness of the deposit deposited on the surface of the electrode of the piezoelectric resonator for detection. Further, when the instruction unit instructs the sensor module 10 to perform the switching operation of the electrode cover, for example, the thickness determination unit 173 determines the thickness of the deposit deposited on the surface of the electrode exposed in accordance with the instruction. Since the operation of determining the thickness of the deposit by the thickness determination unit 173 is the same as the operation of the control device 100 using the sensor module 10 of the second configuration example, the description thereof will be omitted here.

The lifetime estimation unit 174 estimates a lifetime of the piezoelectric resonator for detection based on the initial oscillation frequency information read from the storage circuit 16 by the memory control unit 172 and the measurement result obtained by the frequency measurement unit 140. For example, when the piezoelectric resonator for reference has not been used as the piezoelectric resonator for detection in the past, the lifetime estimation unit 174 estimates the lifetime of the piezoelectric resonator for detection in the same manner as in the lifetime estimation unit 174 of the control device 100 using the sensor module 10 of the second configuration example. As described above, the lifetime estimation unit 174 identifies the piezoelectric resonator for detection based on the information read from the storage circuit 16 of the sensor module 10 or the information read from the storage unit 150 of the control device 100.

Furthermore, when the instruction unit instructs the sensor module 10 to perform the switching operation of the electrode cover, the lifetime estimation unit 174 estimates the lifetime of the piezoelectric resonator having the electrode exposed in accordance with the instruction of the instruction unit among the first piezoelectric resonator 31 and the second piezoelectric resonator 33. In this case, since the piezoelectric resonator for reference has been used as the piezoelectric resonator for detection in the past, the lifetime estimation unit 174 does not use the first threshold value based on the above-described initial oscillation frequency information. The lifetime estimation unit 174 uses a threshold value based on a terminal oscillation frequency which is the oscillation frequency of the piezoelectric resonator for reference.

For example, it is assumed that the first piezoelectric resonator 31 is a piezoelectric resonator for reference used as the piezoelectric resonator for detection in the past, and the terminal oscillation frequency is denoted by f₁3. In other words, for example, the first piezoelectric resonator 31 is a resonator that has been determined by the lifetime estimation unit 174 as having reached the end of its lifetime as the piezoelectric resonator for detection when |f₁3-f₂1| (or |f₁3-f₂2|) becomes equal to or greater than the first threshold value, and has been switched to the piezoelectric resonator for reference by the instruction unit.

In this case, the measurement result of the oscillation frequency of the second piezoelectric resonator 33 used as the resonator for detection is denoted by f₂3. The lifetime estimation unit 174 estimates the lifetime of the second piezoelectric resonator 33 in response toΔf3 (=f₂3- f₁3), the difference frequency between the oscillation frequency f₂3 of the second piezoelectric resonator 33 for detection and the oscillation frequency f₁3 (terminal oscillation frequency) of the first piezoelectric resonator 31, becoming equal to or less than the third threshold value based on the initial oscillation frequency information. It should be noted that the oscillation frequency of the first piezoelectric resonator 31 for reference may vary depending on the ambient temperature or the like. Therefore, the oscillation frequency of the first piezoelectric resonator 31 for reference may be further measured and defined as f₁3.

For example, it is assumed that the second piezoelectric resonator 33 reaches the end of its lifetime when the oscillation frequency f₂3 is reduced by 97 kHz from the first frequency f₂0 which is the initial frequency. Here, a frequency of 97 kHz, indicating an index at which the second piezoelectric resonator 33 reaches the end of its lifetime, is defined as fₜ2. In this case, the third threshold value may be set to fₜ1-fₜ2 (= -2Hz), a difference between fₜ2 and a frequency indicating an index at which the first piezoelectric resonator 31 reaches the end of its lifetime, that is, fₜ1.

It should be noted that the first frequency f₁0, which is the initial frequency of the first piezoelectric resonator 31, and the second frequency f₂0, which is the initial frequency of the second piezoelectric resonator 33, may differ from each other due to variations among individual resonators and the like. In this case, the third threshold value may be a value obtained by adding, to fₜ1-fₜ2, the difference between the first frequency f₁0 and the second frequency f₂0. For example, the difference between the initial frequencies of the first piezoelectric resonator 31 and the second piezoelectric resonator 33, that is, (f₂0-f₁0) is 5 kHz. In this case, the first threshold is set to fₜ1-fₜ2+(f₂0-f₁0) = 3kHz.

As described above, the lifetime estimation unit 174 can estimate the lifetime of the first piezoelectric resonator 31 by comparing the oscillation frequency f₁3 of the first piezoelectric resonator 31 and the oscillation frequency f₂3 of the second piezoelectric resonator 33. It should be noted that the lifetime estimation unit 174 may compare the oscillation frequency f₁3 of the first piezoelectric resonator 31 and the oscillation frequency f₂3 of the second piezoelectric resonator 33 after performing the temperature compensation. Alternatively, when the temperature characteristics of the two piezoelectric resonators are substantially the same, the lifetime estimation unit 174 is not required to perform the temperature compensation on the oscillation frequency. Accordingly, the lifetime estimation unit 174 can estimate the lifetime of the first piezoelectric resonator 31 more easily.

Although an example in which the sensor module 10 of the present embodiment includes two piezoelectric resonators has been described, the present disclosure is not limited thereto. Instead of the above, a module having a plurality of sensor modules 10 may be used as the sensor module. Such a module will be described below.

### <Fourth configuration example of sensor module>

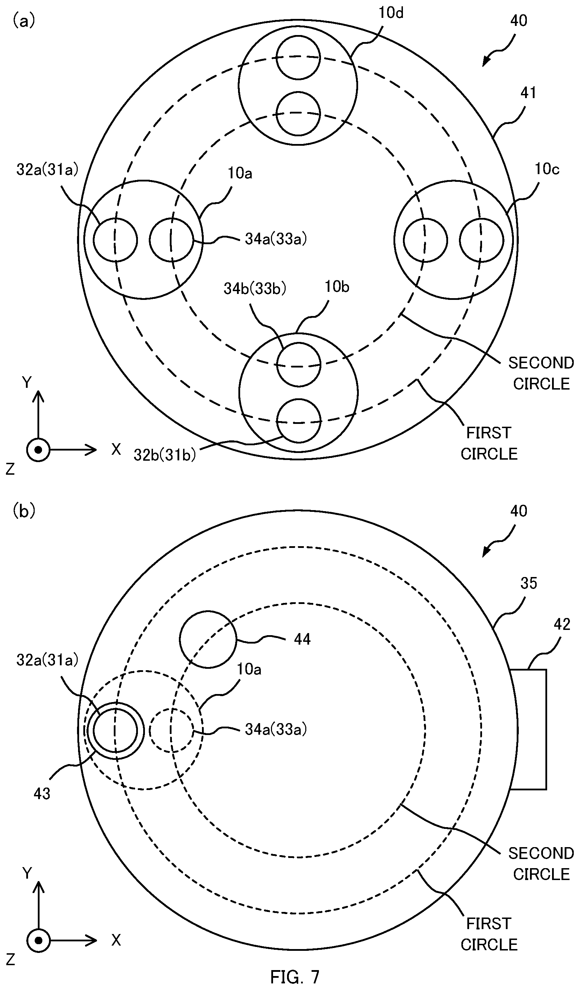

FIG. 7 shows a fourth configuration example of the sensor module according to the present embodiment as a sensor module 40. The sensor module 40 of the fourth configuration example is a module including a plurality of the sensor modules 10 of the third configuration example shown in FIG. 6. The sensor module 40 of the fourth configuration example further includes a fixed substrate 41 and a moving unit 42.

FIG. 7(a) shows a configuration example in a plan view of the sensor module 40 in a state in which the electrode cover 35 is removed. In the sensor module 40 of the fourth configuration example, the plurality of the sensor modules 10 of the third configuration example are provided on the fixed substrate 41. The fixed substrate 41 is a plate-shaped member on which the sensor modules 10 are disposed. The fixed substrate 41 may be formed integrally with the substrate 11 of the sensor module 10.

In FIG. 7(a), four modules, a sensor module 10a, a sensor module 10b, a sensor module 10c, and a sensor module 10d, are the sensor module 10 of the third configuration example. In other words, the sensor module 40 of the fourth configuration example includes a plurality of combinations of the first piezoelectric resonator 31 and the second piezoelectric resonator 33.

For example, the first electrodes 32 of the plurality of first piezoelectric resonators 31 are disposed along the circumference of a first circle having a predetermined radius on the upper surface of the fixed substrate 41. FIG. 7(a) shows an example in which the four first electrodes 32 are disposed on the circumference of the first circle at substantially the same angular intervals (90-degree intervals). Similarly, the second electrodes 34 of the plurality of second piezoelectric resonators 33 are disposed along the circumference of a second circle concentric with the first circle on the upper surface of the fixed substrate 41. FIG. 7(a) shows an example in which the four second electrodes 34 are disposed at substantially the same angular intervals (90-degree intervals) on the circumference of the second circle.

FIG. 7(b) shows a configuration example in a plan view of the sensor module 40 to which the electrode cover 35 is attached. In FIG. 7(b), a portion of the sensor module 10a covered with the electrode cover 35, the first circle, and the second circle are indicated by dotted lines. The electrode cover 35 of the sensor module 40 of the fourth configuration example is provided as a single common cover for the plurality of combinations of first piezoelectric resonators 31 and the second piezoelectric resonator 33.

The moving unit 42 moves the electrode cover 35. The moving unit 42 includes an actuator or the like, and moves the electrode cover 35 based on a control signal received from the outside of the sensor module 40 (for example, an instruction unit or the like of the control device 100). In other words, the electrode cover 35 is configured in a movable plate shape while covering the plurality of first electrodes 32 and the plurality of second electrodes 34. FIG. 7(b) shows an example in which the electrode cover 35 is formed in a disk shape and is provided so as to be rotatable by the moving unit 42 while covering the plurality of first piezoelectric resonators 31 and the plurality of second piezoelectric resonators 33. The electrode cover 35 has a first opening 43 and a second opening 44.

The first opening 43 is an opening for exposing one of the plurality of first electrodes 32. The first opening 43 is disposed to sequentially move, as the electrode cover 35 moves, to a plurality of positions corresponding to the plurality of first electrodes 32 so as to expose the plurality of first electrodes 32 one by one.

In the electrode cover 35, the first opening 43 is provided on a circumference of a circle that coincides, in plan view, with the first circle of the fixed substrate 41. Then, the moving unit 42 rotates the electrode cover 35 about an axis passing through the center of the first circle perpendicularly in the plan view as a rotation axis, thereby exposing one first electrode 32 among the plurality of first electrodes 32 through the first opening 43. FIG. 7(b) shows an example in which the first opening 43 exposes the first electrode 32a of the sensor module 10a.

The second opening 44 is an opening for exposing one of the plurality of second electrodes 34. The second opening 44 is disposed to sequentially move, as the electrode cover 35 moves, to a plurality of positions corresponding to the plurality of second electrodes 34 so as to expose the plurality of second electrodes 34 one by one.

In the electrode cover 35, the second opening 44 is provided on a circumference of a circle that coincides, in plan view, with the second circle of the fixed substrate 41. Then, the moving unit 42 rotates the electrode cover 35 about the axis passing through the center of the first circle in plan view as the rotation axis, thereby exposing one second electrode 34 among the plurality of second electrodes 34 through the second opening 44.

The first opening 43 is disposed so that, when the second opening 44 moves to a position where the second opening 44 exposes the second electrode 34, the first opening 43 moves to a position where the first opening 43 does not expose the first electrode 32. Similarly, the second opening 44 is disposed so that, when the first opening 43 moves to a position where the first opening 43 exposes the first electrode 32, the second opening 44 moves to a position where the second opening 44 does not expose the second electrode. When the moving unit 42 rotates such an electrode cover 35, the electrode cover 35 exposes either one first electrode 32 through the first opening 43 or one second electrode 34 through the second opening 44, among the plurality of first electrodes 32 and the plurality of second electrodes 34.

FIG. 7(b) shows an example in which the first opening 43 exposes the first electrode 32a of the sensor module 10a, and the second opening 44 does not expose any electrode. In the sensor module 40 in such a state, the first piezoelectric resonator 31a of the sensor module 10a can operate as the piezoelectric resonator for detection, and the second piezoelectric resonator 33a of the sensor module 10a can operate as the piezoelectric resonator for reference.

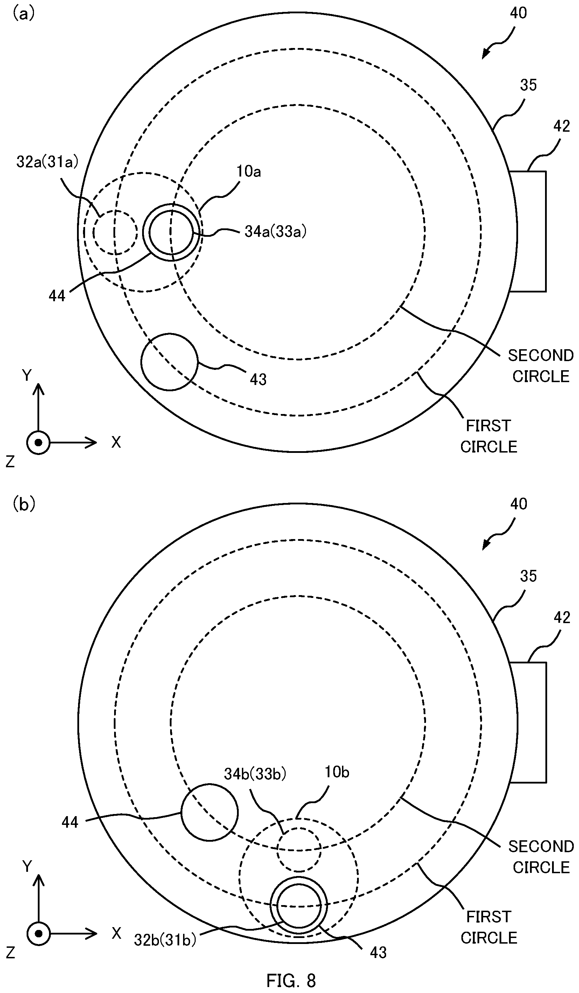

FIG. 8 shows an example in which the electrode cover 35 of the sensor module 40 of the fourth configuration example shown in FIG. 7 is rotated. FIG. 8(a) shows an example in which the electrode cover 35 of the sensor module 40 shown in FIG. 7(b) is rotated 45 degrees. Here, the rotation angle of the electrode cover 35 is half the angle of the interval in which the first electrode 32 and the second electrode 34 are arranged on the circumference.

As can be seen from FIG. 8(a), no electrode is exposed through the first opening 43, and the second electrode 34a of the sensor module 10a is exposed through the second opening 44. In the sensor module 40 in such a state, the first piezoelectric resonator 31a of the sensor module 10a can operate as the piezoelectric resonator for reference, and the second piezoelectric resonator 33a of the sensor module 10a can operate as the piezoelectric resonator for detection.

FIG. 8(b) shows an example in which the electrode cover 35 of the sensor module 40 shown in FIG. 8(a) is further rotated 45 degrees. As can be seen from FIG. 8(b), the first opening 43 exposes the first electrode 32b of the next sensor module 10b, and the second opening 44 does not expose any electrode. In the sensor module 40 in such a state, the first piezoelectric resonator 31b of the sensor module 10b can operate as the piezoelectric resonator for reference, and the second piezoelectric resonator 33b of the sensor module 10b can operate as the piezoelectric resonator for detection.

As described above, in the sensor module 40, the electrodes of the plurality of piezoelectric resonators can be sequentially exposed one by one, and the piezoelectric resonator with an exposed electrode can operate as the piezoelectric resonator for detection. It should be noted that the piezoelectric resonator for reference may be any piezoelectric resonator that is covered by the electrode cover 35. A plurality of piezoelectric resonators may be alternately used one by one as the piezoelectric resonator for reference, or alternatively, a predetermined piezoelectric resonator may be used as the piezoelectric resonator for reference.

It should be noted that also in the sensor module 40 of the fourth configuration example, the storage circuit 16 of the sensor module 10 having the piezoelectric resonator that operates as the piezoelectric resonator for detection (and/or reference) may store information indicating the piezoelectric resonator for detection (and/or reference). Further, the storage circuit 16 may store information indicating that the first piezoelectric resonator 31 and/or the second piezoelectric resonator 33 cannot be used as the piezoelectric resonator for detection when the first piezoelectric resonator 31 and/or the second piezoelectric resonator 33 that has operated as the piezoelectric resonator for detection and reached the end of its lifetime. In addition, these pieces of information may be stored in the storage unit 150 of the control device 100.

### <Operation of control unit 100 using sensor module 40 of fourth configuration>

The control device 100 shown in FIG. 3 can also use the sensor module 40 of the fourth configuration example. Also in this case, the control device 100 is connected to the sensor module 40 of the fourth configuration example via the interface 120. It should be noted that the memory control unit 172 may access the storage circuits 16 of the plurality of sensor modules 10 to read information stored in the storage circuits 16.

The control unit 170 further includes an instruction unit that instructs the moving unit 42 of the sensor module 40 to operate the electrode cover. The instruction unit instructs movement of the electrode cover 35 so that i) the first opening 43 is positioned at a position corresponding to the first piezoelectric resonator 31 of one combination or ii) the second opening 44 is positioned at a position corresponding to the second piezoelectric resonator 33 of the one combination, among the plurality of combinations of the first piezoelectric resonator 31 and the second piezoelectric resonator 33.

Here, one combination of the first piezoelectric resonator 31 and the second piezoelectric resonator 33 is a combination of the first piezoelectric resonator 31 and the second piezoelectric resonator 33 included in one sensor module 10, for example. Further, one combination of the first piezoelectric resonator 31 and the second piezoelectric resonator 33 may be a combination of the first piezoelectric resonator 31 included in one sensor module 10 and the second piezoelectric resonator 33 included in another sensor module 10 that is different from the one sensor module 10.

The control unit 170 transmits a control signal to the oscillation circuit 15 corresponding to the first piezoelectric resonator 31 and the second piezoelectric resonator 33 of the one combination to drive the first piezoelectric resonator 31 and the second piezoelectric resonator 33 of the one combination. The frequency measurement unit 140 measures the oscillation frequencies of the first piezoelectric resonator 31 and the second piezoelectric resonator 33 of the one combination, based on the oscillation frequency signal output from the oscillation circuit 15.

The thickness determination unit 173 determines the thickness of the deposit deposited on the surface of the electrode of the piezoelectric resonator for detection exposed by the instruction of the instruction unit, among the first electrode 32 of the first piezoelectric resonator 31 and the second electrode 34 of the second piezoelectric resonator 33, based on the measurement result obtained by the frequency measurement unit 140. The operation of the thickness determination unit 173 to determine the thickness may be the same as the operation of the control device 100 described above, and a description thereof will be omitted here.

Based on the initial oscillation frequency information read from the storage circuit 16 by the memory control unit 172 and the measurement result obtained by the frequency measurement unit 140, the lifetime estimation unit 174 estimates the lifetime of the piezoelectric resonator of the piezoelectric resonator for detection having the electrode exposed by the instruction of the instruction unit among the first piezoelectric resonator 31 and the second piezoelectric resonator 33. The operation of the lifetime estimation unit 174 to estimate the lifetime may be the same as the operation of the control device 100 described above, and the description thereof will be omitted here.

The control device 100 according to the present embodiment described above can estimate the lifetimes of a plurality of piezoelectric resonators mounted on the sensor module 40 while easily replacing the piezoelectric resonator for detection by using the sensor module 40 of the fourth configuration example. In the sensor module 40 of the fourth configuration example, the plurality of first electrodes 32 and the plurality of second electrodes are concentrically arranged, but the present disclosure is not limited thereto. The plurality of first electrodes 32 and the plurality of second electrodes may be linearly arranged.

### <Fifth configuration example of sensor module>

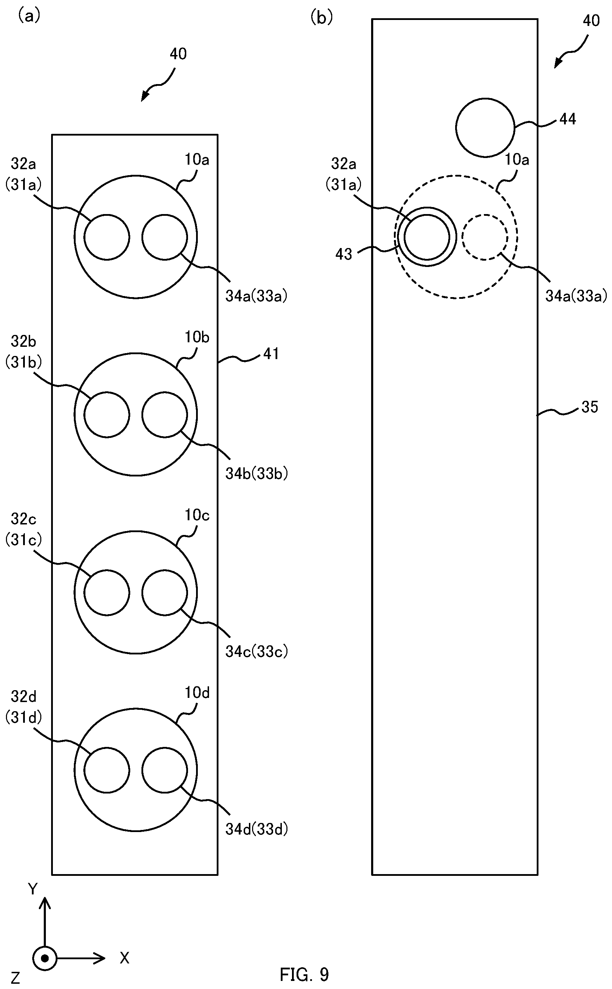

FIG. 9 shows a fifth configuration example of the sensor module 10 according to the present embodiment. In the sensor module 40 of the fifth configuration example, components that are substantially the same as those of the sensor module 40 of the fourth configuration example shown in FIG. 7 are denoted by the same reference numerals, and redundant descriptions thereof are omitted.

FIG. 9(a) shows a configuration example in a plan view of the sensor module 40 in a state in which the electrode cover 35 is removed. In the sensor module 40 of the fifth configuration example, a plurality of the sensor modules 10 of the third configuration example are linearly provided on the fixed substrate 41.

FIG. 9(b) shows a configuration example in a plan view of the sensor module 40 to which the electrode cover 35 is attached. In FIG. 9(b), a portion of the sensor module 10a covered with the electrode cover 35 is indicated by a dotted line. The first opening 43 exposes the first electrode 32a of the sensor module 10a, and the second opening 44 does not expose any electrode. When the electrode cover 35 moves in a Y-direction and the second opening 44 exposes the second electrode 34a of the sensor module 10a, the first opening 43 is positioned so as not to expose any electrode.

Further, when the electrode cover 35 moves in the Y-direction and the first opening 43 exposes the first electrode 32b of the sensor module 10b, the second opening 44 is positioned so as not to expose any electrode. As described above, in the sensor module 40 of the fifth configuration example, the electrodes of the plurality of piezoelectric resonators can be sequentially exposed one by one, and the piezoelectric resonator with an exposed electrode can operate as the piezoelectric resonator for detection.

As described above, even in the sensor module 40 of the fifth configuration example, the control device 100 can estimate the lifetimes of the plurality of piezoelectric resonators mounted on the sensor module 40 while easily replacing the piezoelectric resonator for detection. It should be noted that, in the sensor module 40 according to the present embodiment, it is desirable that the storage circuit 16 of at least the piezoelectric resonator used last stores, in addition to the first threshold value used for estimating the lifetime, a second threshold value used to determine that the end of the lifetime is approaching. Accordingly, the user can grasp that the replacement time of the entire sensor module 40 is approaching.

The present disclosure is explained on the basis of the exemplary embodiments. The technical scope of the present disclosure is not limited to the scope explained in the above embodiments and it is possible to make various changes and modifications within the scope of the disclosure. For example, all or part of the apparatus can be configured with any unit which is functionally or physically dispersed or integrated. Further, new exemplary embodiments generated by arbitrary combinations of them are included in the exemplary embodiments of the present disclosure. Further, effects of the new exemplary embodiments brought by the combinations also have the effects of the original exemplary embodiments.

### [Description of Symbols]

1: semiconductor manufacturing apparatus
2: chamber
3: stage
4: film forming device
5: connector
10: sensor module
11: substrate
12: piezoelectric resonator
13: electrode
14: heater circuit
15: oscillation circuit
16: storage circuit
17: base member
18: coupling socket
19: temperature sensor
20: cover
30: connection cable
31: first piezoelectric resonator
32: first electrode
33: second piezoelectric resonator
34: second electrode
35: electrode cover
40: sensor module
41: fixed substrate
42: moving unit
43: first opening
44: second opening
100: control device
110: input unit
120: interface
130: power supply unit
140: frequency measurement unit
150: storage unit
160: display unit
170: control unit
171: acquisition unit
172: memory control unit
173: thickness determination unit
174: lifetime estimation unit
175: display control unit

## Claims

1. A sensor module comprising:
a first piezoelectric resonator that has a first electrode;
a second piezoelectric resonator that has a second electrode;
an electrode cover that covers one of the first electrode and the second electrode;
an oscillation circuit that drives and oscillates each of the first piezoelectric resonator and the second piezoelectric resonator; and
a storage circuit that stores, as initial oscillation frequency information, information corresponding to i) a first oscillation frequency measured by causing the first piezoelectric resonator to oscillate upon shipment of the first piezoelectric resonator and ii) a second oscillation frequency measured by causing the second piezoelectric resonator to oscillate upon shipment of the second piezoelectric resonator, wherein
at least one of the first piezoelectric resonator and the second piezoelectric resonator that is not covered by the electrode cover oscillates, when driven by the oscillation circuit, at a frequency corresponding to a thickness of a deposit deposited on a surface of an electrode that is exposed and not covered by the electrode cover.

2. The sensor module according to claim 1, wherein
the storage circuit further stores information of a resonator identification number for identifying the first piezoelectric resonator and the second piezoelectric resonator.

3. The sensor module according to claim 1, wherein
the electrode cover is switchable between a state in which the electrode cover covers the first electrode and a state in which the electrode cover covers the second electrode,
the first piezoelectric resonator, when driven by the oscillation circuit, oscillates at a frequency corresponding to a thickness of a deposit deposited on a surface of the first electrode,
the second piezoelectric resonator, when driven by the oscillation circuit, oscillates at a frequency corresponding to a thickness of a deposit deposited on a surface of the second electrode, and
the electrode cover exposes the first electrode when covering the second electrode and preventing deposits from being deposited on the surface of the second electrode, and exposes the second electrode when covering the first electrode and preventing deposits from being deposited on the surface of the first electrode.

4. The sensor module according to claim 3, wherein
when the electrode cover is switched to a state of covering the first electrode after the first piezoelectric resonator is driven by the oscillation circuit, the storage circuit stores, as terminal oscillation frequency information, an oscillation frequency measured by causing the first piezoelectric resonator to oscillate.

5. The sensor module according to claim 3 comprising:
a plurality of combinations of the first piezoelectric resonator and the second piezoelectric resonator, wherein
the electrode cover is configured in a movable plate shape while covering the plurality of first electrodes and the plurality of second electrodes,
the electrode cover has a first opening for exposing one of the first electrodes and a second opening for exposing one of the second electrodes,
the first opening is disposed to sequentially move, as the electrode cover moves, to a plurality of positions corresponding to the plurality of first electrodes so as to expose the plurality of first electrodes one by one,
the second opening is disposed to sequentially move, as the electrode cover moves, to a plurality of positions corresponding to the plurality of second electrodes so as to expose the plurality of second electrodes one by one, and
the sensor module further comprises a moving unit that moves the electrode cover.

6. The sensor module according to claim 5, wherein
a plurality of the first piezoelectric resonators are disposed along a circumference of a first circle having a predetermined radius on an upper surface of a fixed substrate,
a plurality of the second piezoelectric resonators are disposed along a circumference of a second circle concentric with the first circle on the upper surface of the fixed substrate,
the electrode cover is rotatably provided while covering a plurality of the first piezoelectric resonators and a plurality of the second piezoelectric resonators,
in the electrode cover, the first opening is provided on a circumference of a circle coinciding with the first circle in plan view, and the second opening is provided on a circumference of a circle coinciding with the second circle in plan view, and
the moving unit exposes either one of the first electrodes through the first opening or one of the second electrodes through the second opening, among a plurality of the first electrodes and a plurality of the second electrodes, by rotating the electrode cover about an axis passing through the center of the first circle perpendicularly in plan view as a rotation axis.

7. A measurement system comprising:
the sensor module according to any one of claims 1 to 6; and
a control device that is connected to the sensor module, wherein
the control device includes:
a memory control unit that is capable of accessing the storage circuit of the sensor module to read information stored in the storage circuit,
a frequency measurement unit that measures oscillation frequencies of the first piezoelectric resonator and the second piezoelectric resonator, based on an oscillation frequency signal output from the oscillation circuit,
a thickness determination unit that determines a thickness of the deposit deposited on a surface of an electrode that is exposed and not covered by the electrode cover among the first electrode of the first piezoelectric resonator and the second electrode of the second piezoelectric resonator, based on a measurement result obtained by the frequency measurement unit, and
a lifetime estimation unit that estimates a lifetime of a piezoelectric resonator with an electrode that is exposed and not covered by the electrode cover among the first piezoelectric resonator and the second piezoelectric resonator, based on the initial oscillation frequency information read from the storage circuit by the memory control unit and a measurement result obtained by the frequency measurement unit.

8. The measurement system according to claim 7, wherein
the lifetime estimation unit estimates a lifetime of the first piezoelectric resonator in response to an absolute value of a difference frequency between an oscillation frequency of the first piezoelectric resonator and an oscillation frequency of the second piezoelectric resonator becoming equal to or greater than a first threshold value based on the initial oscillation frequency information.

9. The measurement system according to claim 8, wherein
the storage circuit of the sensor module further stores information of the first threshold value based on the initial oscillation frequency information.

10. The measurement system according to claim 8, wherein
the storage circuit of the sensor module further stores information of a second threshold value having an absolute value smaller than that of the first threshold, and
the lifetime estimation unit determines that the end of a lifetime of the first piezoelectric resonator is approaching in response to an absolute value of a difference frequency between an oscillation frequency of the first piezoelectric resonator and an oscillation frequency of the second piezoelectric resonator becoming equal to or larger than the second threshold value.

11. A measurement system comprising:
the sensor module according to claim 3 or 4; and
a control device that is connected to the sensor module, wherein
the control device includes:
a memory control unit that is capable of accessing the storage circuit of the sensor module to read information stored in the storage circuit,
an instruction unit that instructs the sensor module to perform a switching operation of the electrode cover,
a frequency measurement unit that measures oscillation frequencies of the first piezoelectric resonator and the second piezoelectric resonator, based on an oscillation frequency signal output from the oscillation circuit,
a thickness determination unit that determines a thickness of the deposit deposited on a surface of an electrode exposed by an instruction of the instruction unit among the first electrode of the first piezoelectric resonator and the second electrode of the second piezoelectric resonator, based on a measurement result obtained by the frequency measurement unit, and
a lifetime estimation unit that estimates a lifetime of a piezoelectric resonator having an electrode exposed by an instruction of the instruction unit, among the first piezoelectric resonator and the second piezoelectric resonator, based on initial oscillation frequency information read from the storage circuit by the memory control unit and a measurement result obtained by the frequency measurement unit.

12. A measurement system comprising:
the sensor module according to claim 5 or 6; and
a control device that is connected to the sensor module, wherein
the control device includes:
a memory control unit that is capable of accessing the storage circuit of the sensor module to read information stored in the storage circuit,
an instruction unit that instructs movement of the electrode cover so that i) the first opening is positioned at a position corresponding to the first piezoelectric resonator of one combination or ii) the second opening is positioned at a position corresponding to the second piezoelectric resonator of one combination, among a plurality of combinations of the first piezoelectric resonators and the second piezoelectric resonators,
a frequency measurement unit that measures oscillation frequencies of the first piezoelectric resonator and the second piezoelectric resonator of the one combination, based on an oscillation frequency signal output from the oscillation circuit,
a thickness determination unit that determines a thickness of the deposit deposited on a surface of an electrode exposed by an instruction of the instruction unit among the first electrode of the first piezoelectric resonator and the second electrode of the second piezoelectric resonator, based on a measurement result obtained by the frequency measurement unit, and
a lifetime estimation unit that estimates a lifetime of a piezoelectric resonator having an electrode exposed in response to an instruction from the instructing unit, among the first piezoelectric resonator and the second piezoelectric resonator, based on the initial oscillation frequency information read from the storage circuit by the memory control unit and a measurement result obtained by the frequency measurement unit.
